# EUROPEAN PATENT APPLICATION

(11) **EP 3 598 859 A1**
(43) Date of publication of application: **22.01.2020**
(21) Application number: 17900259.7
(22) Date of filing: 09.03.2017
(51) Int. Cl.: H05K 7/20, F25B 19/04, H01L 23/427

(54) **HEAT DISSIPATION METHOD AND HEAT DISSIPATION SYSTEM**

(30) Priority: 07.03.2017 JP 2017042521
(71) Applicant: Feather Grass Co., Ltd., Tokyo 103-0013 (JP); Hashiba, Tomohiko, Tokyo 103-0013 (JP)
(72) Inventor: HASHIBA Tomohiko, Tokyo 103-0013 (JP)
(74) Representative: Schön, Christoph
(86) International application number: PCT/JP2017/009488
(87) International publication number: WO 2018/163355

(57) **Abstract**

The present invention relates to a process for removing heat, comprising the steps of: generating liquid fine particles comprising at least one vaporable liquid; transporting the liquid fine particles to a heat source; and vaporizing the liquid fine particles in the vicinity of the heat source without contacting the liquid fine particles with the heat source, wherein the heat of the heat source is removed by the heat of vaporization of the liquid fine particles, as well as a system for removing heat which can perform the process for removing heat. The process and system for removing heat according to the present invention can exert high cooling efficiency because they can directly remove heat from the heat source.

## Description

### TECHNICAL FIELD

The present invention relates to a process and system for directly removing heat from any heat source such as a semiconductor device in electronic devices.

### BACKGROUND ART

The technology for cooling electronic devices such as servers in server racks from outside by utilizing latent heat of evaporation of liquid droplets has been known. As an example thereof, mention may be made of a cooling system constituted by disposing spray nozzles which have the same or similar structure as sprinklers for fires in a server room, wherein water droplets sprayed downward from the vicinity of the ceiling of the server room can cool the whole server room including a plurality of server racks. As another example, mention may be made of a cooling system constituted by spraying water liquid into each server rack to cool each of the server racks (cf. Patent Document 1).

However, in the above conventional cooling system, the temperature and humidity tend to vary depending on the site in the server room because the whole server room is cooled at once by using spray nozzles which have the same or similar structure as sprinklers for fires, and therefore, it is difficult to cool each of the electronic devices such as servers and routers contained in the server rack. Also, in order to prevent water-leaking into the electronic devices, a dehumidification or decompression means is necessary to promote complete evaporation of relatively large water droplets sprayed into the server room or server racks.

In Patent Document 2, a cooling system for electronic devices is disclosed which can cool every electronic device contained in a server rack, by utilizing the heat of evaporation of a mist which comprises fine liquid particles, and does not need a dehumidification or decompression means in order to prevent water-leaking into the electronic devices to be cooled.
Patent Document 1: JP-A-2009-110469
Patent Document 2: JP-A-2014-173805

### DISCLOSURE OF INVENTION

More precisely, the electronic devices such as servers do not generate heat from the whole thereof, but generate heat from a heat source such as a CPU which is a limited part present therein. However, the technique disclosed in Patent Document 2 cools the whole of the electronic devices, not the heat source such as a CPU, and therefore, there is a limit to enhancement of cooling efficiency.

An objective of the present invention is to provide a technique which can exert high cooling efficiency when cooling targets such as electronic devices.

The objective of the present invention can be achieved by a process for removing heat, comprising the steps of:
generating liquid fine particles comprising at least one vaporable liquid;
transporting the liquid fine particles to a heat source; and
vaporizing the liquid fine particles in the vicinity of the heat source without contacting the liquid fine particles with the heat source,
wherein
the heat of the heat source is removed by the heat of vaporization of the liquid fine particles.

It is preferable that the step of transporting the liquid fine particles be performed by a gas flow.

It is preferable that the gas comprise air.

It is preferable that the liquid fine particles not be electrified.

It is preferable that the vaporable liquid comprise water.

It is preferable that the maximum particle size of the liquid fine particle be less than 1 µm.

It is preferable that the heat source be a semiconductor device.

The objective of the present invention can also be achieved by a system for removing heat, comprising:
at least one liquid fine particle generator which is capable of generating liquid fine particles comprising at least one vaporable liquid;
at least one liquid fine particle transporting conduit which is capable of transporting the liquid fine particles generated by the liquid fine particle generator to a heat source; and
a control device which is capable of controlling the particle size of the liquid fine particles generated by the liquid fine particle generator, and/or the generating amount of the liquid fine particles, and/or the transporting speed of the liquid fine particles,
wherein
the heat of the heat source is removed by the heat of vaporization of the liquid fine particles.

The phrase "controlling the particle size of the liquid fine particles generated by the liquid fine particle generator, and/or the generating amount of the liquid fine particles, and/or the transporting speed of the liquid fine particles" means controlling at least one, at least two or all of the particle size of the liquid fine particles generated by the liquid fine particle generator, the generating amount of the liquid fine particles, and the transporting speed of the liquid fine particles.

It is preferable that the system for removing heat further comprise a gas flow supplying device for supplying a gas flow into the liquid fine particle transporting conduit.

It is preferable that the control device be capable of controlling the flow speed of the gas flow.

It is preferable that the gas comprise air.

It is preferable that the liquid fine particles not be electrified.

It is preferable that the vaporable liquid comprise water.

It is preferable that the maximum particle size of the liquid fine particle be less than 1 µm.

It is preferable that the heat source be a semiconductor device.

### EFFECTS OF THE INVENTION

The process and system for removing heat according to the present invention transports liquid fine particles to the vicinity of a heat source to directly cool the heat source, when utilizing the heat of vaporization of the liquid fine particles of vaporable liquid for cooling. Therefore, it can exert high cooling efficiency. Accordingly, the present invention can realize effective removal of heat, or cooling, for various targets for cooling such as electronic devices.

The present invention can remove the quantity of heat, which corresponds to the heat of vaporization of liquid fine particles, from the vicinity of heat, by the evaporation of the liquid fine particles, thereby removing heat from (or cooling) the heat source. Therefore, the liquid fine particles do not directly contact the heat source. Accordingly, even if the heat source is an electronic device, no inconveniences such as short circuits in the electronic device will be caused.

In general, when transporting liquid fine particles, the tendency for the liquid fine particles to aggregate during the transportation can increase. However, if the present invention uses liquid fine particles with a maximum particle size of less than 1 µm, and/or liquid fine particles which are not electrified or electrically charged, the aggregation of the liquid fine particles can be effectively controlled or restricted when transporting the liquid fine particles.

The liquid fine particles comprise vaporable liquid and can function as a coolant. As the vaporable liquid, water is preferable in terms of easiness of handling.

If the present invention transports liquid fine particles by a gas flow, the transportation can be performed easily. Also, by controlling the flow speed of the gas flow, the transportation speed of the liquid fine particles can be controlled. From a viewpoint of easy handling, it is preferable that the gas comprise or is air.

If the present invention controls the particle size of the liquid fine particles generated by the liquid fine particle generator, and/or the generating amount of the liquid fine particles, and/or the transporting speed of the liquid fine particles, it is easier to adjust or control such that all the liquid fine particles can be vaporized in the vicinity of heat source without contacting the heat source.

It is preferable that the maximum particle size of the liquid fine particles be less than 1 µm.

The heat source which is the target for removing heat in accordance with the present invention is not limited, and may be any article which can be cooled or the heat of which can be removed. It is preferable that the heat source be a heat-generating element. As examples, mention may be made of a material which can convert electricity to heat. However, it may be a living body such as an animal which may include a human being. Also, the living body may be a plant. In this case, the temperature of the plant can be reduced such that it is lower than ambient temperature. In addition, moisture may be provided to the plant via the pores on the leaves, or the like, of the plant. Alternatively, the heat source may be a non-living material. As examples of such a heat source, mention may be made of a semiconductor device which comprises a fine electronic circuit. In particular, it may be a power semiconductor which can generate a large quantity of heat. In order to further enhance cooling efficiency, it is preferable that the heat source be an article which can generate heat by itself (a heat-generating element), while it is not preferable to target, for cooling, an article which merely conveys heat (e.g., a heat transfer body and a heat radiator) or an article which has a temperature higher than the environment as a result of receiving heat from an article generating heat (e.g., a case covering an article generating heat).

### BRIEF DESCRIPTION OF THE DRAWINGS

FIG. 1 shows a schematic configuration view of an embodiment of the system for removing heat according to the present invention.
FIG. 2 shows a schematic view of a liquid fine particle generator in an embodiment of the system for removing heat according to the present invention.
FIG. 3 shows an enlarged front view of a fine particle sorting plate in an embodiment of the present invention.
FIG. 4 shows an enlarged front view of another fine particle sorting plate in an embodiment of the present invention.
FIG. 5 shows an enlarged front view of the other fine particle sorting plate in an embodiment of the present invention.
FIG. 6 shows a schematic view of a two-fluid nozzle in an embodiment of a liquid fine particle generator in the present invention; (a) shows a side view and (b) shows a cross-sectional view.
FIG. 7 shows a front view of a two-fluid nozzle in an embodiment of a liquid fine particle generator in the present invention.
FIG. 8 shows a system diagram of an embodiment of a liquid fine particle generator in the present invention.
FIG. 9 shows a graph showing the heat-removing effects in Examples 1 and 2 of the present invention wherein the vertical axis means temperature (°C) and the horizontal axis means time (hour:minute: second).

### BEST MODE FOR CARRYING OUT THE INVENTION

The process and system for removing heat according to the present invention are based on cooling a heat source by utilizing the heat of vaporization of liquid fine particles comprising vaporable liquid, and directly remove heat of the heat source by the heat of vaporization of liquid fine particles by transporting the liquid fine particles to the heat source and vaporizing the liquid fine particles in the vicinity of the heat source without contacting the liquid fine particles to the heat source. Here, the term "vicinity" means a range in which the temperature reducing effects by the heat of vaporization of the liquid fine particles can reach the heat source, and for example, it may be within 10 cm or less, preferably within 5 cm or less, and more preferably within 1 cm or less, from the heat source, while it may depend on the situation of the heat source. As explained above, the present invention can directly cool the heat source, and therefore, it can exert high cooling efficacy. Also, the present invention can exert high cooling efficiency without causing condensation of liquid fine particles on the heat source.

It is preferable that the maximum particle size of liquid fine particles be less than 1 µm. Surprisingly, by this, the agglomeration of liquid fine particles can be effectively avoided or reduced. In particular, the present invention can restrict the agglomeration of liquid fine particles when transporting the liquid fine particles. If the liquid fine particles are not electrified or electrically charged, better avoidance or reduction of agglomeration of liquid fine particles can be achieved.

If the present invention controls the maximum particle size of liquid fine particles to be less than 1 µm, it is necessary to control the maximum particle size, not average particle size, to be less than 1 µm. If the average particle size of the liquid fine particles is less than 1 µm, in view of particle size statistical distribution, liquid fine particles with a particle diameter of 1 µm or more must exist. Such liquid fine particles are relatively large so that the tendency of the agglomeration thereof cannot be denied. Thus, the risk that the agglomerated liquid fine particles contact the surface of heat source do exist as condensations can increase.

Hereinafter, an embodiment of the present invention is described with reference to the figures. Although, in the embodiments shown in the figures, the heat source of electronic devices is the target for removing heat or cooling, the heat source can be any article which can be cooled or the heat of which can be removed.

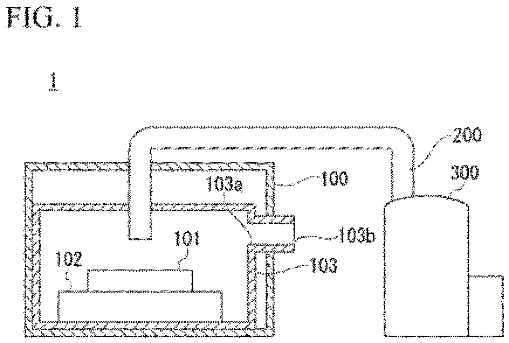

As shown in Fig. 1, the system 1 for removing heat according to an embodiment of the present invention comprises a liquid fine particle generator 300 and a liquid fine particle transporting conduit 200, as well as a control device which is not shown in Fig. 1.

First, the liquid fine particle generator is explained.

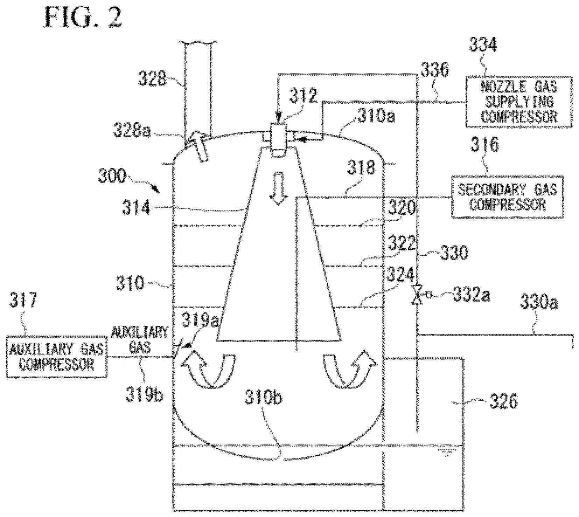

As shown in Fig. 2, the liquid fine particle generator 300 according to an embodiment of the present invention comprises a cylindrical fine particle separating vessel 310 whose lower end is closed and whose upper end is provided with a lid portion 310a. The lid portion 310a of the fine particle separating vessel 310 is provided with a two-fluid nozzle (fine particle generating nozzle) 312 for atomizing vaporable liquid (substance to be sprayed) by gas such as air. Here, the two-fluid nozzle 312 is directed so as to inject gas from a gas injection outlet toward an outer peripheral portion of the liquid injected from an injection outlet provided at a tip end of the nozzle, and injecting fine particles of the vaporable liquid by atomizing the liquid by the gas.

As the above liquid, any type of liquid can be used as long as it is vaporable and can generate the heat of vaporization. In view of easy handling, it is preferable to use water for the above liquid. If necessary, the liquid may comprise an ingredient other than water. As the ingredient other than water, for example, mention may be made of a volatile material such as a fragrance. In view of easy use, it is more preferable that the liquid consist of water.

As shown in Fig. 2, there is provided inside the fine particle separating vessel 310 a flow rectifying cone (flow rectifying member) 314 for flow-straightening and guiding the fine particles of vaporable liquid generated by the two-fluid nozzle 312 to a lower part of the fine particle separating vessel 310. Here, the tip end of the two-fluid nozzle 312 is disposed at an upper opening of the flow rectifying cone 314.

Further, a secondary gas feeding pipe 318 extending from a secondary gas compressor 316 is disposed inside the fine particle separating vessel 310, and a secondary gas such as air from the secondary gas compressor 316 is fed to the vicinity of a lower opening of the flow rectifying cone 314. Further, there are provided inside the fine particle separating vessel 310 fine particle sorting plates 320, 322, 324 for controlling floating up of the fine particles guided to the lower part of the fine particle separating vessel 310 by the flow rectifying cone 314, and for sorting or separating the fine particles.

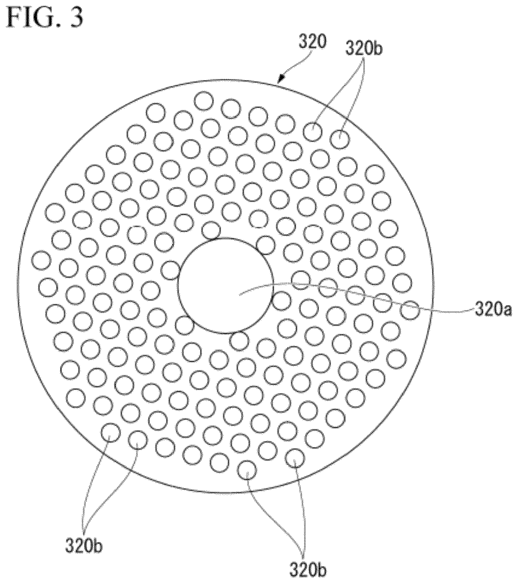

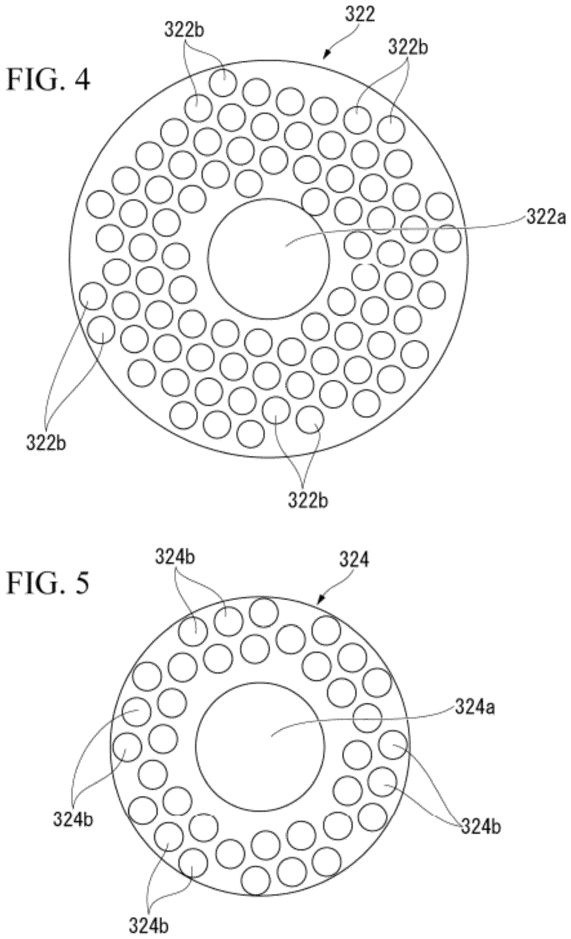

As shown in Fig. 3, the fine particle sorting plate 320 is a plate-shaped member of circular plate shape where an opening 320a through which the flow rectifying cone 314 penetrates is provided at the center thereof, and is provided with a large number of fine particle passing holes 320b. Further, as shown in Fig. 4, the fine particle sorting plate 322 is a plate-shaped member of circular plate shape where an opening 322a through which the flow rectifying cone 314 penetrates is provided at the center thereof, and is provided with a large number of fine particle passing holes 322b. The fine particle passing holes 322b are made to be larger than the fine particle passing holes 320b of the fine particle sorting plate 320. Furthermore, as shown in Fig. 5, the fine particle sorting plate 324 is a plate-shaped member of circular plate shape where an opening 324a through which the flow rectifying cone 314 penetrates is provided at the center thereof, and is provided with a large number of fine particle passing holes 324b. The fine particle passing holes 324b are made to be larger than the fine particle passing holes 322b of the fine particle sorting plate 322.

As shown in Fig. 2, a liquid discharge port 310b connected to a liquid storing vessel 326 is provided at the bottom of the fine particle separating vessel 310. The liquid retained at the bottom of the fine particle separating vessel 310 is discharged from the liquid discharge port 310b to be stored in the liquid storing vessel 326.

Further, a discharging section 328 for discharging particles separated from the fine particles inside the fine particle separating vessel 310 is provided at the lid portion 310a of the fine particle separating vessel 310. Here, the discharging section 328 is attached to the lid portion 310a with a spray port attaching portion 328a, and is connected to the liquid fine particle transporting conduit 200 shown in Fig. 1.

In the embodiment shown in Fig. 2, an auxiliary gas nozzle 319a is provided at the vessel wall of the fine particle separating vessel 310, and is connected to an auxiliary gas supplying pipe 319b extending from an auxiliary gas compressor 317. The injection outlet of the auxiliary gas nozzle 319a is directed to the discharging section 328. The auxiliary gas supplied from the auxiliary gas compressor 317 is discharged, in the fine particle separating vessel 310, upwardly from the auxiliary gas nozzle 319a. In the embodiment shown in Fig. 2, the auxiliary gas compressor 317, the auxiliary gas supplying pipe 319b, and the auxiliary gas nozzle 319a constitute a gas introduction means for introducing gas from outside into the separating vessel 310.

Further, there is provided a liquid supplying pipe 330 for supplying a liquid to the two-fluid nozzle 312 between the liquid storing vessel 326 and the two-fluid nozzle 312. This liquid supplying pipe 330 is provided with a solenoid valve 332a for adjusting the quantity of the liquid to be supplied to the two-fluid nozzle 312. The liquid can be supplied to the two-fluid nozzle 312 via a branch supplying pipe 330a from other than the liquid storing vessel 326. Furthermore, there is provided a gas supplying pipe 336 for supplying a nozzle gas to the two-fluid nozzle 312 between the nozzle gas supplying compressor 334 and the two-fluid nozzle 312.

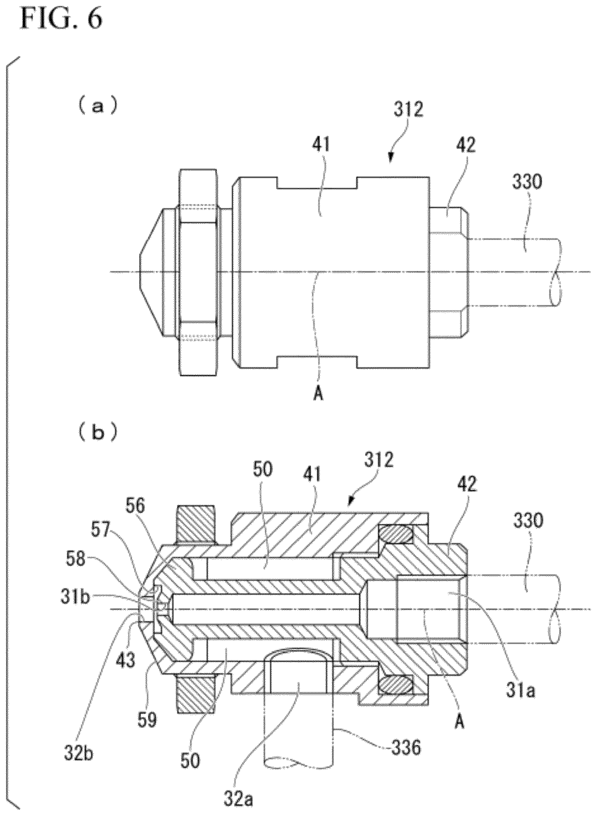

The two-fluid nozzle 312 in this embodiment has a structure, as shown in Fig. 6, wherein a core 42 with a substantially cylindrical shape is inserted inside a hollow casing 41 with a substantially cylindrical shape for integration. At the tip of the casing 41, an opening 43 with a round or circular shape is formed such that the central axis A of the two-fluid nozzle 312 corresponds to the center of the opening. By the opening 43, the outer profile of the gas injecting outlet 32b is formed. At the side surface of the casing 41, a gas supplying port 32a is provided such that the axis thereof is vertical to the central axis A of the two-fluid nozzle 312. A gas supplying pipe 336 is connected to the gas supplying port 32a.

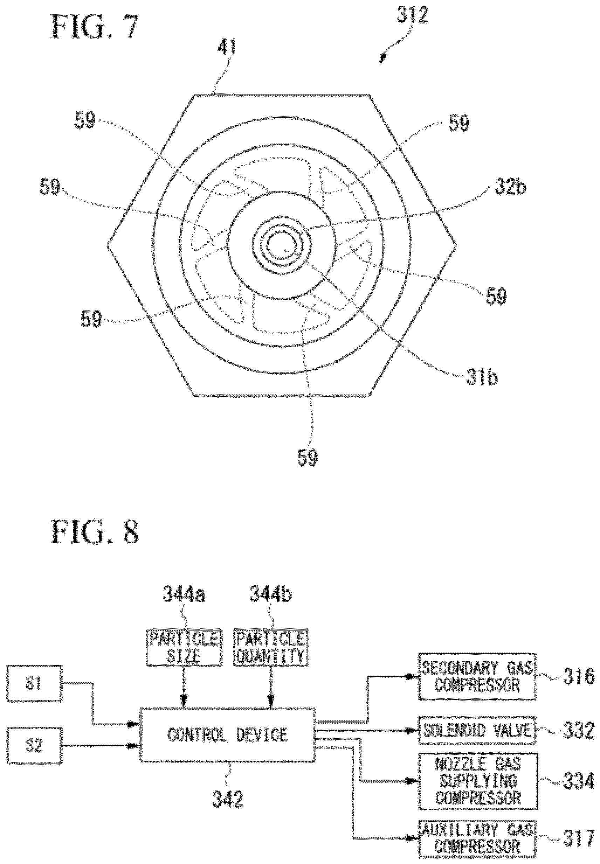

The core 42 is hollow by hollowing out the inside thereof in alignment with the central axis A. Also, the outer diameter thereof has a size such that it can be inserted precisely into the hollow of the casing 41. The central portion of the core 42 along with the longitudinal direction thereof is shaped slightly thin such that a cylindrical space 50 is formed with the inner surface of the casing 41. A liquid supplying port 31a is formed at the base edge of the core 42. A liquid injecting outlet 31b is formed at the tip of the core 42. The liquid supplying port 31a and the liquid injecting outlet 31b are connected to each other via a flow channel going through the axis of the core 42. The liquid supplying port 31 is connected to the liquid supplying pipe 330. Around the liquid injecting outlet 31b, a vortex current former 56 is formed. The vortex current former 56 has a tip surface with a cone shape, and a plurality of rotational grooves 59 with spiral shapes are formed (see Fig. 7) on the tip surface with a cone shape. Between the tip surface of the vortex current former 56 and the inner surface of the tip of the casing 41, a vortex current compartment 57 is formed. The tip surface 58 of the core 42 forming the vortex current compartment 57 has a gap between the inner wall of the opening 43 of the casing 41, and the gap forms the gas injecting outlet 32b.

As shown in Fig. 7, the liquid injecting outlet 31b is positioned at the center of the two-fluid nozzle 312, and the gas injecting outlet 32b is arranged around the liquid injecting outlet 31b. The gas injecting outlet 32b is connected to the vortex current compartment 57.

The gas supplied from the gas supplying port 32a into the two-fluid nozzle 312 goes through the space 50 and is compressed when going through the rotational grooves 59 of the vortex current former 56 to form a high-speed gas current. This high-speed gas current becomes a spiral gas flow, and is injected from the narrow circular gas injecting outlet 32b to form a gas flow rotating with high speed in front of the two-fluid nozzle 312. This rotating gas flow (spiral gas flow) is formed into the shape of a cone with a focus which is located near the front of the casing 41.

On the other hand, a liquid is supplied to the liquid supplying port 31a via the liquid supplying pipe 330. The liquid goes through the hollow of the core 42 from the liquid supplying port 31a and is injected from the liquid injecting outlet 31b. The injected liquid is atomized by the rotating high-speed gas flow injected from the gas injecting outlet 32b to be a fine mist (liquid fine particles), and is discharged at the front side of the two-fluid nozzle 312.

If necessary, a power device for supplying electrical charge to the liquid fine particles to be discharged from the discharging section 328 may be connected to the two-fluid nozzle 312.

A desired DC voltage can be supplied to the two-fluid nozzle 312 by this power device so that the fine particles to be discharged from the discharging section 328 are charged. However, it is preferable that the fine particles not be charged as explained below.

The pressure of the secondary gas to be fed from the above secondary gas compressor 316 into the fine particle separating vessel 310, the pressure to be fed from the auxiliary gas compressor 317 to the fine particle separating vessel 310, the pressure of the nozzle gas to be fed to the two-fluid nozzle 312 by the nozzle gas supplying compressor 334, and the quantity of the liquid to be supplied to the two-fluid nozzle 312 via the solenoid valve 332a can be controlled by a control device 342 (refer to Fig. 8). In other words, the control device 342 can function as a first gas pressure control means for controlling the pressure of the nozzle gas to be fed to the two-fluid nozzle 312, a second gas pressure control means for controlling the pressure of the secondary gas to be fed into the fine particle separating vessel 310, an auxiliary gas pressure control means for controlling the pressure of the auxiliary gas to be fed into the fine particle separating vessel 310, and a liquid quantity control means for controlling the quantity of the liquid to be supplied to the two-fluid nozzle 312. If the above power device is present, the control device 342 controls the type and quantity of electrical charge (electrostatic charge) to be supplied to the two-fluid nozzle 312 by the power device.

Further, a particle size detecting section S1 for detecting a particle size of the liquid fine particles to be discharged from the discharging section 328, and a particle quantity detecting section S2 for detecting the particle quantity of the fine particles are connected to the control device 342, and detection values from the particle size detecting section S1 and the particle quantity detecting section S2 are input therein. Furthermore, the control device 342 is connected to a particle size setting section 344a for setting a particle size of the fine particles to be discharged from the discharging section 328, and a particle quantity setting section 344b for setting the particle quantity of the fine particles. If the above power device is present, an electrical charge setting section for setting the type and quantity of electrostatic charge (quantity of electrical charge to be supplied) of the fine particles is connected to the control device 342.

Next, the generation of fine particles by the liquid fine particle generator 300 will be described. In the following, a description will be given by way of an example where liquid is supplied to the two-fluid nozzle 312, and air, as a nozzle gas, a secondary gas and an auxiliary gas, is supplied so that the fine particles of the liquid are generated.

First, the particle size of the fine particles of the liquid to be discharged from the discharging section 328 is set by the particle size setting section 344a, and the particle quantity of the fine particles to be discharged from the discharging section 328 is set by the particle quantity setting section 344b.

After the setting of the particle size of the fine particles and the setting of the particle quantity of the fine particles are terminated, the fine particles of the liquid are generated. In other words, in this liquid fine particle generator 300, when air (nozzle gas) is fed from the nozzle gas supplying compressor 334 to the two-fluid nozzle 312 via the gas feeding pipe 336, this air is injected from the gas injecting outlet at the tip end of the two-fluid nozzle 312, and the liquid in the liquid storing vessel 326 is sucked up by this injection force and supplied to the two-fluid nozzle 312 via the liquid supplying pipe 330.

In the two-fluid nozzle 312, as mentioned above, the liquid which will be injected from the liquid injecting outlet is atomized by the air injected from the gas injecting outlet so that the fine particles of the liquid are injected. The fine particles injected from this two-fluid nozzle 312 are guided through the flow rectifying cone 314 to the lower part of the fine particle separating vessel 310. On the other hand, the air (secondary gas) from the secondary gas compressor 316 is fed to the vicinity of the lower opening of the flow rectifying cone 314 via the secondary gas feeding pipe 318. In addition, the air (auxiliary gas) from the auxiliary gas compressor 317 is fed into the fine particle separating vessel 310 via the auxiliary gas supplying pipe 319b, and discharged from the auxiliary gas nozzle 319a toward the discharging section 328.

While the fine particles guided to the lower part of the fine particle separating vessel 310 are trying to float up or rise due to an upward flow of the air (nozzle air) fed from the two-fluid nozzle 312, the secondary air and the auxiliary air, floating up or rising is restricted or controlled by the fine particle sorting plates 320, 322, and 324. Thus, they gradually or slowly float up or rise inside the fine particle separating vessel 310 through the fine particle passing holes 320b, 322b, and 324b provided at the fine particle sorting plates 320, 322, and 324, respectively. In other words, first, the fine particles which passed through the fine particle sorting plate 324 are restricted from floating up or rising by the fine particle sorting plate 322, and fine particles having a predetermined particle size are retained between the fine particle sorting plate 324 and the fine particle sorting plate 322. Here, fine particles having a large particle size drop on the bottom of the fine particle separating vessel 310 due to the force of gravity.

Then, the fine particles which passed through the fine particle sorting plate 322 are restricted from floating up or rising by the fine particle sorting plate 320, and the fine particles having a predetermined particle size are retained between the fine particle sorting plate 322 and the fine particle sorting plate 320. Here, fine particles having a large particle size drop on the bottom of the fine particle separating vessel 310 due to the force of gravity. The particle size of the fine particles retained between the fine particle sorting plate 322 and the fine particle sorting plate 320 is made smaller than the particle size of the fine particles retained between the fine particle sorting plate 324 and the fine particle sorting plate 322.

As the fine particles float up or rise inside the fine particle separating vessel 310 in this manner, the fine particles having a large particle size drop on the bottom of the fine particle separating vessel 310, and only the fine particles having a uniform particle size are discharged from the discharging section 328 of the fine particle separating vessel 310. The liquid retained at the bottom of the fine particle separating vessel 310 is discharged from the discharge port 310b and stored in the liquid storing vessel 326 for recycling.

The particle size of the liquid fine particles discharged from the discharging section 328 is detected by the particle size detecting section S1 and the particle quantity of the liquid fine particles is detected by the particle quantity detecting section S2. The detection values detected by the particle size detecting section S1 and the particle quantity detecting section S2 are input into the control device 342. In the control device 342, control signals are output to the secondary gas compressor 316, the auxiliary gas compressor 317, the solenoid valve 332a, and the nozzle gas supplying compressor 334, in order to control the pressure of the air (nozzle gas) to be fed to the two-fluid nozzle 312, the quantity of the liquid to be supplied to the two-fluid nozzle 312 and the pressure of the secondary gas and the auxiliary gas to be fed to the fine particle separating vessel 10, such that the particle size of the liquid fine particles to be discharged from the discharging section 328 is equal to a value set by the particle size setting section 344a, and the particle quantity of the fine particles is equal to a value set by the particle quantity setting section 344b.

In other words, in the control device 342, when the particle size of the liquid fine particles detected by the particle size detecting section S1 is larger than that set by the particle size setting section 344a, the nozzle gas supplying compressor 334 is controlled so that the pressure of the air (nozzle gas) to be fed to the two-fluid nozzle 312 is increased, and/or, the secondary gas compressor 316 can be controlled to increase the pressure of the air (secondary gas) to be fed into the fine particle separating vessel 310, and/or the auxiliary gas compressor 317 can be controlled to increase the pressure of the air (auxiliary gas) to be fed into the fine particle separating vessel 310. Thereby, the particle size of the liquid fine particles to be discharged from the discharging section 328 can be made smaller.

On the other hand, when the particle size of the liquid fine particles detected by the particle size detecting section S1 is smaller than that set by the particle size setting section 344a, the nozzle gas supplying compressor 334 is controlled to reduce the pressure of the air (nozzle gas) to be fed to the two-fluid nozzle 312, and/or the secondary gas compressor 316 can be controlled to reduce the pressure of the air (secondary gas) to be fed into the fine particle separating vessel 310, and/or the auxiliary gas compressor 317 can be controlled to reduce the pressure of the air (auxiliary gas) to be fed into the fine particle separating vessel 310. Thereby, the particle size of the liquid fine particles to be discharged from the discharging section 328 can be made larger.

Although either the pressure of the air (nozzle gas) to be fed to the two-fluid nozzle 312 or the pressure of the air (secondary gas and/or the auxiliary gas) to be fed into the fine particle separating vessel 310 can be controlled so that the particle size of the liquid fine particles to be discharged from the discharging section 328 can be controlled, at least one, preferably at least two and more preferably all of the pressure of the air (nozzle gas) to be fed to the two-fluid nozzle 312, the pressure of the air (secondary gas) to be fed into the fine particle separating vessel 310, and the pressure of the air (auxiliary gas) to be fed into the fine particle separating vessel 310 controlled by the auxiliary gas compressor 317 can be controlled so that the particle size of the liquid fine particles can be controlled more accurately.

Further, when the quantity of the liquid fine particles detected by the particle quantity detecting section S2 is smaller than the quantity set by the particle quantity setting section 344b, control signals are output to the solenoid valve 332a, to increase the quantity of the liquid to be supplied to the two-fluid nozzle 312. Thereby, the particle quantity of the liquid fine particles to be discharged from the discharging section 328 can be increased. On the other hand, when the quantity of the liquid fine particles detected by the particle quantity detecting section S2 is larger than the quantity set by the particle quantity setting section 344b, control signals are output to the solenoid valve 332a to reduce the quantity of the liquid to be supplied to the two-fluid nozzle 312. Thereby, the particle quantity of the liquid fine particles to be discharged from the discharging section 328 can be reduced.

In this liquid fine particle generator 300, the above control may be repeated until the particle size of the liquid fine particles detected by the particle size detecting section S1 becomes equal to the particle size set by the particle size setting section 344a and the particle quantity of the liquid medicine detected by the particle quantity detecting section S2 becomes equal to the particle quantity set by the particle quantity setting section 344b.

Although the above auxiliary gas introduction means may not be provided to the vessel wall of the fine particle separating vessel 310, it is preferable that the auxiliary gas introduction means be provided. Thereby, the control of the particle size and/or the discharging amount can be controlled better.

In this liquid fine particle generator 300, a valve, which is not shown in the figures but is provided at the discharging section 328, can be opened only when necessary so that the liquid fine particles can be delivered to the liquid fine particle transporting conduit 200.

According to the liquid fine particle generator 300 of this embodiment, liquid can be sprayed as fine particles having a uniform particle size set by the particle size setting means, and the liquid fine particles can be discharged only when necessary. Since the liquid fine particles can be generated at the desired particle size, large benefits can be obtained by a small quantity of the liquid. Further, since it is possible to prevent generation of an excessive amount of liquid which is more than necessary, the consumption of the liquid can be reduced.

Further, in this embodiment, by using the fine particle separating vessel 310 with the fine particle sorting plates 320, 322 and 324, and controlling the particle diameter as explained above, the maximum diameter of the liquid fine particles can be set and fine particles with a uniform particle diameter predetermined by the particle size setting means can be sprayed. In the present invention, it is preferable that the maximum diameter of the liquid fine particles be less than 1 µm.

It is preferable that the liquid fine particles not be electrified or electrically charged. However, if they are electrified, the liquid fine particles to be discharged from the discharging section 328 can be electrified by using the electrical charge setting section as explained above. Thus, if the electrical charge amount is set by the electrical charge setting means, the control device 324 can output control signals based on the set value to the power device, and can control the electrical charge amount to be supplied to the two-fluid nozzle 312 from the power device.

Furthermore, in the above embodiment, although when air is fed to the two-fluid nozzle 312, this air is injected from the gas injecting outlet at the tip end of the two-fluid nozzle 312, and the liquid in the liquid storing vessel 326 can be sucked up by this injection force to be supplied to the two-fluid nozzle 312, in the case where the viscosity of the liquid is remarkably high, for example, the liquid may be guided to the liquid injecting outlet of the two-fluid nozzle 312 by using a pump or the like so that fine particles of the liquid can be similarly generated.

As explained above, the liquid fine particle generator 300 comprises a two-fluid nozzle 312 (Fig. 2) which can generate a mist by discharging liquid from the liquid injecting outlet 31b (Fig. 6(b) and Fig. 7) and atomizing the liquid with a high-speed gas spiral flow injected from the gas injecting outlet 32b (Fig. 6(b) and Fig. 7). The liquid fine particles generated by the two-flow nozzle 312 are transported via the liquid fine particle transporting conduit 200.

Next, the liquid fine particle transporting conduit will be explained.

The liquid fine particle transporting conduit 200 constitutes a passage for the liquid fine particle (mist) generated by the liquid fine particle generator 300, and can transport the mist floating in the gas in the passage. In the embodiment shown in Fig. 1, one end of the liquid fine particle transporting conduit 200 is connected to the discharging section 328 (not shown in Fig. 1) of the liquid fine particle generator 300, and the other end thereof is positioned and opened at the vicinity of a heat source 101 in the electronic device 100. Thus, liquid fine particle transporting conduit 200 can transport liquid fine particles generated by the liquid fine particle generator 300 to the vicinity of the heat source 101.

It is preferable in the present invention that the maximum diameter of the mist be less than 1 µm. Thereby, the agglomeration of mist, in particular during transportation, can be effectively avoided or reduced. Accordingly, in this embodiment of the present invention, the mist can be transported to the heat source as they are fine particles. If the mist is not electrified, the agglomeration of the mist by electrostatic force can be restricted, and therefore, the avoidance or the reduction of the agglomeration of the mist can be performed better. Also, the adhesion of the mist to the inner surface of the liquid fine particle transporting conduit 200 can be avoided or reduced, and therefore, the transportation of mist can also be facilitated.

In the embodiment shown in Fig. 1, the heat source 101 is a semiconductor device positioned on the substrate 102. However, the type of the heat source 101 is not limited. Therefore, any heat generating element in the electronic device 100 may be the heat source 101.

In the embodiment shown in Fig. 1, the heat source 101 is surrounded by a case 103. At the case 103, a vent 103a is formed. Also, at the vent 103a, a forced vent means 103b such as a fan, the details of which are not shown in the figure, is provided in order to make it possible to vent out the atmosphere in the case 103 to outside of the case 103, and further outside of the electronic device 100.

Thus, in the embodiment shown in Fig. 1, it is possible to vent out the gas in the case 103 by activating the forced vent means 103b, providing negative pressure to the inside of the case 103. Thereby, the liquid fine particles in the liquid fine particle transporting conduit 200 are sucked into the case 103, and can be transported to the vicinity of the heat source 101 by a gas flow. The forced vent means 103b may not be present, if the liquid fine particles can be transported into the case 103 via the liquid fine particle transporting conduit 200 by, for example, the injection power from the two-fluid nozzle (spray nozzle) 312 of the liquid fine particle generator 300 without the forced vent means 103b.

The liquid fine particle transporting conduit 200 may comprise at least one gas flow supplying means to supply a gas flow into the liquid fine particle transporting conduit 200, if necessary, at any position thereof. The gas flow supplying means is not limited, but may be a blowing device such as a fan. The number of the gas flow supplying means is also not limited. A plurality of gas flow supplying means, if necessary, may be provided in one liquid fine particle transporting conduit 200. Due to the presence of the gas flow supplying means, the transportation of liquid fine particles in the liquid fine particle transporting conduit 200 can be secured. For example, even if the liquid fine particle transporting conduit 200 is long, the liquid fine particles can be stably transported.

The type of the gas in the liquid fine particle transporting conduit 200 and/or the case 103 is not limited. For example, any gas which is a gas at a room temperature (25°C) such as nitrogen gas can be used. However, in terms of handling, air is preferable.

In the embodiment shown in Fig. 1, one heat source 101 is present in the electronic device 100. However, a plurality of heat sources may be present in the electronic device 100. In this case, for each of the heat sources, the system 1 for removing heat shown in Fig. 1 can be provided.

The system 1 for removing heat according to the present invention can remove heat from the heat source by using the heat of vaporization. Therefore, it can remove heat from the heat source more effectively as compared to another method for removing heat utilizing heat conduction by a heat pump, a heat radiation plate, and the like.

The system 1 for removing heat according to the present invention can directly remove heat from the heat source 101 in the electronic device 100. Therefore, it can make it possible to more effectively remove heat as compared to the case of indirectly removing heat from the outer surface of the electronic device 100 by spraying a mist on the outer surface of the electronic device 100. In addition, removing heat from the outer surface of the electronic device 100 requires a relatively large amount of mist, while the system 1 for removing heat according to the present invention can limit the amount of generated mist to enhance heat removing efficiency because it needs to supply mist only to the part of the heat source 101.

In the embodiment shown in Fig. 1, the liquid fine particle generator 300 and most of the liquid fine particle transporting conduit 200, which are elements constituting the system 1 for removing heat, are provided outside of the electronic device 100. However, at least one of these elements may be provided in the electronic device 100, and it may be preferable that all of these elements be provided in the electronic device 100.

Next, an example of removing heat by using the system 1 for removing heat according to one embodiment of the present invention will be explained.

First, liquid fine particles (mist) are generated by the liquid fine particle generator 300. It is preferable that the maximum particle size of the liquid fine particle be less than 1 µm. For example, it may be in a range of from 0.1 to less than 1 µm, preferably from 0.2 to 0.9 µm, and more preferably from 0.3 to 0.8 µm. The liquid fine particles having a maximum particle size of less than 1 µm do not include liquid fine particles having a particle size of 1 µm or more. Thus, for example, liquid fine particles having an average particle size of less than 1 µm can include liquid fine particles with a particle size of 1 µm or more, as a part thereof, depending on a particle size distribution. However, liquid fine particles having a maximum particle size of less than 1 µm do not include such relatively large particles. Thus, liquid fine particles with a maximum particle size of less than 1 µm has a size of nano-microns and can be in the form of so-called nano-fine particles. If the particle size of liquid fine particles is less than 1 µm, the risk of agglomeration can be reduced as compared to liquid fine particles of a larger size, and the delivery to the space around the heat source 101 can be facilitated because they can be easily delivered to the heat source 101 by a gas flow. If the liquid fine particles are not electrified, the transportation of the liquid fine particles can be facilitated as compared to electrified particles because the risk of agglomeration of liquid fine particles can be reduced. Accordingly, it is preferable that the liquid fine particles have no electrical charge (not electrified). The liquid is not limited as long as it is vaporable. However, water is preferable.

Next, the atmosphere in the case 103 is vented out by activating the forced vent means 103b to generate negative pressure in the case 103. Thereby, the liquid fine particles generated by the liquid fine particle generator 300 are sucked into the liquid fine particle transporting conduit 200, the liquid fine particles in the liquid fine particle transporting conduit 200 are transported by a gas flow and introduced into the electronic device 100, and the liquid fine particles are discharged in the vicinity of the heat source 101 from the opening of the liquid fine particle transporting conduit 200. The process for removing heat according to the present invention can transport the liquid fine particles to the heat source 101 in the electronic device 100 as explained above.

Even if the forced vent means 103b is not present, if the liquid fine particles can be transported into the case 103 via the liquid fine particle transporting conduit 200 by, for example, the injection power from the spray nozzle 312 of the liquid fine particle generator 300, the liquid fine particles can be transported to the heat source 101 even without activating the forced vent means 103b.

The liquid fine particles transported to the vicinity of the heat source 101 vaporize without contacting the heat source, thereby removing heat corresponding to the heat of vaporization from the vicinity of the heat source 101, resulting in the removal of heat from the heat source 101.

Depending on the type of the heat source 101, it is in particular preferable for the liquid fine particles not to directly contact the heat source 101. For example, if the heat source 101 is a semiconductor device comprising a fine electronic circuit, short circuits and the like may occur when liquid fine particles contact the heat source 101 depending on the type of the liquid fine particles. Therefore, it is preferable that the liquid fine particles vaporize before contacting the heat source 101 exerting heat removing effects by removing heat corresponding to the heat of vaporization from the surrounding of the heat source 101.

It is preferable to control the position of vaporization such that all liquid fine particles can vaporize before contacting the heat source 101 by controlling the particle size of the liquid fine particles generated by the liquid fine particle generator, and/or the generating amount of the liquid fine particles, and/or the transporting speed of the liquid fine particles. The control of the position of vaporization can be performed by, for example, adjusting the particle size and amount of the liquid fine particles to be discharged from the liquid fine particle generator 300, and/or adjusting the activation of the forced vent means 103b.

The process for removing heat according to the present invention can remove heat from a heat source by using the heat of vaporization of liquid fine particles. Therefore, it can remove heat from the heat source more effectively as compared to another process for removing heat utilizing heat conduction by a heat pump, a heat radiation plate, and the like.

The process for removing heat according to the present invention can directly remove heat from the heat source 101 in the electronic device 100. Therefore, it can make it possible to more effectively remove heat as compared to the case of indirectly removing heat from the outer surface of the electronic device 100 by spraying a mist on the outer surface of the electronic device 100. In addition, removing heat from the outer surface of the electronic device 100 requires a relatively large amount of mist, while the process for removing heat according to the present invention can limit the amount of generated mist to enhance heat removing efficiency because it need to supply a mist only to the part of the heat source 101.

The present invention is not limited to the above embodiment. For example, in the above embodiment, one liquid fine particle transporting conduit 200 is connected to the liquid fine particle generator 300. However, a plurality of liquid fine particle transporting conduits may be connected to the liquid fine particle generator 300. Also, it may be possible that one liquid fine particle transporting conduit 200 is connected to the liquid fine particle generator 300 while the liquid fine particle transporting conduit 200 has one or more branches each of which has an opening or openings which can discharge liquid fine particles. Also, the electronic device 100 may comprise a plurality of heat sources. If the electronic device 100 comprises a plurality of heat sources, one case 103 may comprise a plurality of heat sources, or a plurality of cases may be present and each may comprise one or more heat sources.

### EXAMPLES

The present invention will be described below in a more detailed manner by way of examples. However, these examples should not be construed as limiting the scope of the present invention. The examples below are presented as non-limiting illustrations in the field of the present invention.

### [Example 1]

As an example of removing heat in accordance with the present invention, removing heat from a CPU of a personal computer was performed. As the personal computer, Compaq 6000 Pro by Hewlett-Packard was used. As the CPU, Core 2 E7500 (2.93 Hz) was used. As the OS, Windows®7 was used.

Specifically, the board equipped with a CPU was taken out from the body of the personal computer, and was surrounded by a box made from heat sealing material (corresponding to the case 103). Next, a hole was made on one of the side surfaces of the box, and a tube (corresponding to the liquid fine particle transporting conduit 200) was introduced into the hole such that one end of the tube was positioned near the heat radiation plate of the CPU. On the top surface of the box, a hole for venting (corresponding to the vent 103a) was also made and a fan (corresponding to the forced vent means 103b) was provided to make forced venting possible.

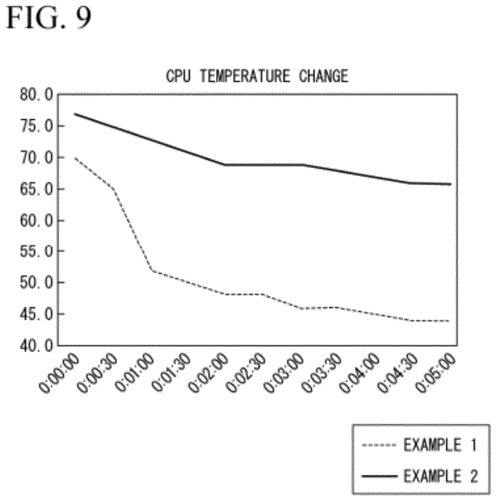

As the liquid fine particle generator, the generator shown in Figs. 2 to 8 was used. The other end of the tube was connected to the discharging section of the liquid fine particle generator such that liquid fine particles can be discharged from one end of the tube. As the liquid, water was used. The maximum diameter of liquid fine particles to be discharged from one end of the tube was set to be 100 nm. Then, at the atmospheric temperature of 25°C, for 5 minutes, the fan was activated to generate negative pressure around the CPU. The water fine particles were introduced from the liquid fine particle generator over the heat radiation plate of the CPU. By visual observation, the heat radiation plate of the CPU was not wet. Therefore, it is clear that all the water fine particles vaporized over the heat radiation plate of the CPU. The temperature of the CPU was measured, and the change thereof over time was recorded. The result is shown in Fig. 9.

### [Example 2]

Liquid fine particles were introduced over the heat radiation plate of the CPU under the same conditions as Example 1 with the proviso that the maximum particle diameter of the liquid fine particles to be discharged from the liquid fine particle generator was set to be 1 µm. By visual observation, the heat radiation plate of the CPU was not wet. Therefore, it is clear that all the water fine particles vaporized over the heat radiation plate of the CPU. The temperature of the CPU was measured, and the change thereof over time was recorded. The result is shown in Fig. 9.

### [Results]

As shown in Fig. 9, both Examples 1 and 2 were able to cool the CPU over time. On the other hand, the temperature reduction of the CPU in Example 1 was much larger than that in Example 2. It is clear that removing heat by the heat of vaporization was performed more effectively in Example 1 than Example 2 because liquid particles which are finer in Example 1 than Example 2 vaporized over the heat radiation plate of the CPU. The amount of water used was smaller in Example 1 than Example 2. Accordingly, Example 1 is technically more advantageous than Example 2.

### LIST OF REFERENCE SYMBOLS

- 1:: System for removing heat
- 200:: Liquid fine particle transporting conduit
- 300:: Liquid fine particle generator

## Claims

1. A process for removing heat, comprising the steps of:
generating liquid fine particles comprising at least one vaporable liquid;
transporting the liquid fine particles to a heat source; and
vaporizing the liquid fine particles in the vicinity of the heat source without contacting the liquid fine particles with the heat source,
wherein
the heat of the heat source is removed by the heat of vaporization of the liquid fine particles.

2. The process according to Claim 1, wherein
the step of transporting the liquid fine particles is performed by a gas flow.

3. The process according to Claim 2, wherein the gas comprises air.

4. The process according to any one of Claims 1 to 3, wherein the liquid fine particles are not electrified.

5. The process according to any one of Claims 1 to 4, wherein the vaporable liquid comprises water.

6. The process according to any one of Claims 1 to 5, wherein the maximum particle size of the liquid fine particle is less than 1 µm.

7. The process according to any one of Claims 1 to 6, wherein the heat source is a semiconductor device.

8. A system for removing heat, comprising:
at least one liquid fine particle generator which is capable of generating liquid fine particles comprising at least one vaporable liquid;
at least one liquid fine particle transporting conduit which is capable of transporting the liquid fine particles generated by the liquid fine particle generator to a heat source; and
a control device which is capable of controlling the particle size of the liquid fine particles generated by the liquid fine particle generator, and/or the generating amount of the liquid fine particles, and/or the transporting speed of the liquid fine particles
wherein
the heat of the heat source is removed by the heat of vaporization of the liquid fine particles.

9. The system for removing heat according to Claim 8, further comprising:
a gas flow supplying device for supplying a gas flow into the liquid fine particle transporting conduit.

10. The system for removing heat according to Claim 9, wherein the control device is capable of controlling the flow speed of the gas flow.

11. The system for removing heat according to Claim 9 or 10, wherein the gas comprises air.

12. The system for removing heat according to any one of Claims 8 to 11, wherein the liquid fine particles are not electrified.

13. The system for removing heat according to any one of Claims 8 to 12, wherein the vaporable liquid comprises water.

14. The system for removing heat according to any one of Claims 8 to 13, wherein the maximum particle size of the liquid fine particle is less than 1 µm.

15. The system for removing heat according to any one of Claims 8 to 14, wherein the heat source is a semiconductor device.
